# EUROPEAN PATENT APPLICATION

(11) **EP 3 730 956 A1**
(43) Date of publication of application: **28.10.2020**
(21) Application number: 19170827.0
(22) Date of filing: 24.04.2019
(51) Int. Cl.: G01R 31/327

(54) **APPARATUS AND METHOD FOR A POST-MORTEM ANALYSIS OF INDUSTRIAL RELAY PRODUCTS**

(71) Applicant: ABB Schweiz AG, 5400 Baden (CH)
(72) Inventor: Lill, Dirk, 79100 Freiburg im Breisgau (DE)
(74) Representative: Maiwald Patent- und Rechtsanwaltsgesellschaft mbH

(57) **Abstract**

The invention relates to an audit device apparatus and a method for auditing an electronic relay apparatus. The audit device (50) comprises:
an audit interface (51), configured to transfer audit data from at least one component of the relay apparatus (10), wherein the audit data are a function of a state of the at least one component and/or of an environment of the electronic relay apparatus (10), to the audit device (50);
a non-volatile memory (54, 55), configured to store the audit data; and
a reading interface (58), configured to read the audit data from the non-volatile memory (54, 55).

## Description

### FIELD OF THE INVENTION

The invention relates to an apparatus and a method for auditing an electronic relay apparatus. Furthermore, the invention relates to a use, a program element and a computer-readable device.

### BACKGROUND OF THE INVENTION

For improving the quality of relay products, some manufacturers give their customers an opportunity to send in relay apparatuses or relay products, which are damaged or destroyed when run by the customer. Some manufacturers give their customers even financial incentives when they send in damaged relay products. These relay products are often sent to the manufacturer's Quality Management (QM) department for an analysis, e.g. for a so-called post-mortem analysis ("analysis after death"). For the analysis, the products may, for instance, be disassembled and/or powered up. This may lead to considerable effort for the analysis. Moreover, for at least some of the analyzed relay products, the cause and/or the root cause of the damage - in spite of the effort - cannot be detected.This analysis may even be worse for configurable relay products.

### SUMMARY OF THE INVENTION

It is one task of this invention to ease the damage cause analysis of damaged relay products.

One first aspect of the invention relates to an audit device for auditing an electronic relay apparatus or relay product at least partly, the audit device comprising: an audit interface, configured to transfer audit data from at least one component of the relay apparatus, wherein the audit data are a function of a state of the at least one component and/or of an environment of the electronic relay apparatus;
a non-volatile memory, configured to store the audit data; and
a reading interface, configured to read the audit data from the non-volatile memory.

The electronic relay apparatus may be, for instance, a timer relay, a safety relay, and/or another type of relay. The relay may be configured for monitoring and/or protection of DC and AC currents and/or voltages, e.g. for overflow and/or underflow of predefined values of currents and/or voltages, and/or, e.g., for phase failure monitoring and/or protection. At least some relay apparatuses may be configurable, at least some relay apparatus by a multitude of parameters. For some relay apparatuses, configuration (sometimes including tuning) is done manually or by using some, i.e. a few, digital signals during end-of-line test and configuration. Some relay apparatuses are pre-configured devices, i.e. they are configured by using e.g. an online configurator and/or by a ROM (Read-Only Memory) that becomes part of the relay apparatus when manufactured. Some relay apparatuses may be configurable and/or may be (re-)configured during life-time, e.g. by service personnel or by the customer, some of them several times, by changing at least some contents of a non-volatile so-called configuration memory or configuration module. The configuration module may comprise, e.g., a Flash Memory and/or an EEPROM.

The audit device is a device that makes at least some data of the relay apparatus available for an analysis. The audit device may be an integral part of the relay apparatus. At least some parts of the audit device may be used for other purposes than only for auditing, e.g. for exchanging data with some components of the relay apparatus. The audit device may be designed as a separate device that is accessible from at least some components of the relay apparatus.

The audit device comprises the audit interface. The audit interface is configured to transfer audit data from at least one component of the relay apparatus to the audit device. The audit interface may, additionally, transfer other data than audit data. The at least one component may be, for instance, a contactor or relay, a monitoring means for the contactor, other sensors (e.g. for temperature or humidity), a processor and/or a processing unit (e.g. with memory), a configuration module, a means for a supply voltage (e.g. a power supply unit, a power adaptor, or the like) for the complete relay apparatus or for one or more of its components, etc. The audit interface may be a serial or a parallel connection, the connection may be wired of wireless. The audit interface may run, for example, protocols like RS.232, USB (Universal Serial Bus), Bluetooth, NFC (Near Field Communication), proprietary protocols using RFID (Radio-Frequency Identification) and/or optocouplers, memory buses, and/or other protocols.

The audit data are a function of a state of the at least one component and/or of an environment of the electronic relay apparatus. The function of the state of a component may comprise, e.g., data of its status (e.g. "operating"/"not-operating"), its operating times and/or duration, its supply voltage and/or current, particularly minimum values and/or maximum values of its state, and/or its configuration data. The function of the environment may comprise, e.g., data of its temperature, its humidity, its air pressure, and/or other environmental data. The function of a state may comprise an error log.

The audit device further comprises the non-volatile memory that is configured to store the audit data. The non-volatile audit memory may comprise, e.g., a Flash Memory and/or an EEPROM. The non-volatile memory is connected to the the components of the relay apparatus, which provide audit data, at least via the audit interface. The non-volatile audit memory may be designed with some robustness, e.g. against some heat that is produced by components that are going to be damaged. Further robustness may be given against electrical fields, humidity, and/or other effects. The robustness may be provided by means of special covers and/or by placing the non-volatile audit memory distant from components with (in comparison with others) higher damage probability.

The audit device further comprises the reading interface, which is configured to read the audit data from the non-volatile memory. The reading interface may be the same interface as the audit interface or a different interface. The reading interface may run, for example, protocols like RS.232, USB (Universal Serial Bus), Bluetooth, NFC (Near Field Communication), proprietary protocols using RFID (Radio-Frequency Identification) and/or optocouplers, memory buses, and/or other protocols. The non-volatile audit memory and the reading interface may be combined, e.g. leading to a solution that stores audit data - e.g. the latest configuration, logged extreme conditions, and/or an error log - in an NFC chip that contains an EEPROM or flash memory. Furthermore, the reading interface may provide access to audit data without opening the relay apparatus.

The audit device improves and eases a damage cause analysis of damaged relay products significantly. The audit device is even suitable for a so-called post-mortem failure analysis. By gathering meaningful audit data from a selection of components, not only important data at the failure's point in time may be available and/or accessible, but also, e.g., boundary conditions and/or some history of audit data may be used for the failure analysis. Particularly for complex relay apparatuses, an acces to latest configuration data may be possible. For at least some relay apparatuses, there is some chance given to perform a root-cause analysis, e.g. in cases when a "failure-chain" can be provided, for instance like "inappropriate values of component A lead to overheating component B, etc." At least for some relay apparatuses, the situation leading to the damage may then be reproduced, and some advice for safe operation may be given.

In addition, the audit device may improve the operating of an relay apparatus, e.g. by the capability of reading a current internal state of the relay apparatus with low effort. This may avoid effort and may reduce downtime. The audit device, further, may give the chance of predictive maintenance, e.g. by saving the relay apparatus' data to a server, e.g. to a cloud, and to perform analysis on these data.

Furthermore, a system-downtime may be reduced, e.g. by reading the configuration data of the damaged relay apparatus and copying them to a relay apparatus, which is to substitute the damaged one, thus putting the successor relay apparatus into operation quickly.

In various embodiments, the status data of the at least one component comprise at least one of: a status, an error log, a supply voltage, operating voltage, operating current, operating times, and/or configuration data of the at least one component of the electronic relay apparatus.

In various embodiments, the environment data of the relay apparatus comprise inside environment data and/or outside environment data of at least one of: a temperature, an air pressure, a humidity or wetness, an electric field, and/or a magnetic field. The inside environment data comprise environment audit data within the housing of the relay apparatus, the outside environment data comprise environment audit data outside the housing of the relay apparatus.

Some of the audit data may be collected in a part of the non-volatile audit memory called configuration module. The contents of the configuration module may comprise the latest configuration of the relay apparatus stored

Some of the audit data may be collected in a part of the non-volatile audit memory called error logging module, comprising at least the so-called error log. The error log may comprise audit data about at least one of: the supply voltage, the device temperature, the measured maximum and minimum values, a temperature evolution over time, information about an extreme temperature increase, information about an unusual voltage drop or voltage spike on the supply line, etc. The data of the error log may contribute to give hints for damage root cause in case a damage has occurred.

In various embodiments, the at least a first set of the audit data is overwritten, and/or a second set of the audit data, which is distinct from the first part, is protected from being overwritten, and/or a third set of the audit data, which is a subset of the second part, comprises a history of the audit data. At least some of these audit data may carry a time stamp. The number of data in at least one of the sets of the audit data may be zero.

Examples for the first set of the audit data may comprise configuration data. For some analyses, only the last set of configuration data may be of interest. Hence, previous configuration data are overwritten with the most recent ones.

Examples for the second set of the audit data may comprise the serial number of the relay apparatus. To protect these data, helps to get a consistent and/or unique analysis ot the audit data.

Examples for the third set of the audit data may comprise the temperature evolution of one or more components over time. When writing new temperature data, the previous temperature data are protected from being overwritten. This "adding strategy" may help, e.g., to analyse relationship among sets of evolving data, possibly along with the time stamp.

In various embodiments, the reading interface is galvanically decoupled from an outside environment, and/or reading interface is further configured to transfer data from outside the relay apparatus to the components of the relay apparatus, and vice versa.

The reading interface may, for example, be designed as a "contactless" interface, for instance as an optocoupler and/or as an RFID transmitter/receiver. By galvanically decoupling the audit device from the outside environment, the robustness of the relay apparatus may be increased, e.g., by protecting the relay apparatus' components from dirt and other potentially harming substances. The reading interface may thus give access to, e.g., the error logs, which are stored in the non-volatile audit memory, e.g. in the error logging module.

Furthermore, the reading interface may serve to transfer data - including data other than audit data - from outside to the components of the relay apparatus, and vice versa. As an example, the reading interface may further be configured to receive configuration data for the relay apparatus.

Alternatively, a connector might be used for the reading interface. In some variations, this may come without galvanic decoupling and/or without electrically insolating the audit device and other components. This may be a cheaper solution, but has a higher risk of damaging the reading interface, in cases when the relay apparatus is damaged.

In an embodiment, the audit interface and/or the reading interface is galvanically decoupled from the other components of the relay apparatus, and/or the power supply of the audit device is provided via the audit interface and/or the reading interface. In this embodiment the audit device may be run as a kind of separate subsystem within the relay apparatus. This may increase the robustness of the audit device, e.g. by protecting this from an overvoltage.

In an embodiment, the audit device is detachably arranged inside a housing of the electronic relay apparatus, and/or at least parts of the audit device are mechanically, thermally, chemically, electrically, and/or magnetically, protected from the other components of the relay apparatus.

This embodiment realizes a high degree of robustness of the audit device. An embodiment like this may be selected for environments of high safety, where analysis is supposed to be feasible even after a serious damage. Alternatively, only the non-volatile audit memory may have a stronger protection.

A further aspect of the invention comprises a method for auditing an electronic relay apparatus at least partly, the method comprising the steps of:
- transfering audit data from at least one component of the relay apparatus via an audit interface to a non-volatile memory, wherein the audit data are a function of a state of the at least one component and/or of an environment of the electronic relay apparatus;
- storing the audit data in the non-volatile memory; and
- reading the audit data from the non-volatile memory via a reading interface.

In various embodiments, the method comprises the further step of:
- overwriting a first set of the audit data, wherein a second set of the audit data, which is distinct form the first part, is protected from being overwritten.

This clear distinction of data classes may further contribute to a well-structured analysis of the audit data, both for a post-mortem analysis and for a live-analysis.

In various embodiments, the method comprises the further steps of:
- copying at least a subset of the first set of the audit data to an external reader; and
- transferring the subset of the first set of the audit data from the external reader to another relay apparatus.

As an example for data to be copied an transferred, configuration data of the relay apparatus may be considered. For some applications and/or systems, where the relay apparatus is used, an optimal configuration may be time-consuming. By using this method of copying and transferring, configuration data of one optimized relay apparatus may easily be transferred to multiple other relay apparatuses of the same type using the identical default setup, in order to have an optimal and/or uniform system solution. In a case of damage, this may help to keep the system downtime low, because the substitute of the damage relay apparatus can easily be configured with the configuration data of its predecessor. As a variation, the configuration settings for device customization could also be stored in an otherwise accessible memory (e.g. in a cloud system) to be programmed, e.g., by service personnel.

In various embodiments, the method comprises the further step of:
- evaluating at least parts of the audit data by at least one of: comparing the audit data with a functional model of at least one component of the relay apparatus;
   comparing the audit data with a history of the audit data of the relay apparatus; and/or comparing the audit data with a collection of a history of the audit data of other relay apparatuses.

With a functional model of the relay apparatus and/or some of its components, quality may be increased and downtimes may be reduced by giving a chance of predictive maintenance of relay apparatuses. The analysis capabilities and/or quality may further be increased by having a history of the audit data of one and/or many relay apparatuses as an analysis-basis.

In various embodiments, the evaluating is performed after a damage of the relay apparatus. This may not only solve a plethora of problems that occur when damaged devices are to be analysed, but may, in addition, lead to a significant increase of analysis capability, thus also improving the quality and/or proceedings in the quality management of these devices.

A further aspect of the invention comprises a use of an audit device as described above and/or below for auditing an electronic relay apparatus at least partly, wherein the electronic relay apparatus is one of: a thermistor relay, a timer relay, a safety relay, an interface relay, an overload relay, a relay for monitoring and/or protection of DC and AC currents and/or voltages, single-phase or multi-phase, for monitoring and/or protection of overcurrent, undercurrent, and/or current windows, overvoltage, undervoltage, and/or voltage windows, phase failure monitoring and/or correction, and/or a combination of these types.

A further aspect of the invention comprises a computer program product comprising instructions, which, when the program is executed by a computer and/or a controller, cause the computer to carry out the method as described above and/or below.

A further aspect of the invention comprises a computer-readable storage medium where a computer program as described above is stored on.

### BRIEF DESCRIPTION OF THE DRAWINGS

- **Fig. 1**: depicts schematically a first embodiment;
- **Fig. 2**: depicts schematically a second embodiment;
- **Fig. 3**: depicts schematically a method according to an embodiment.

### DETAILED DESCRIPTION OF EXEMPLARY EMBODIMENTS

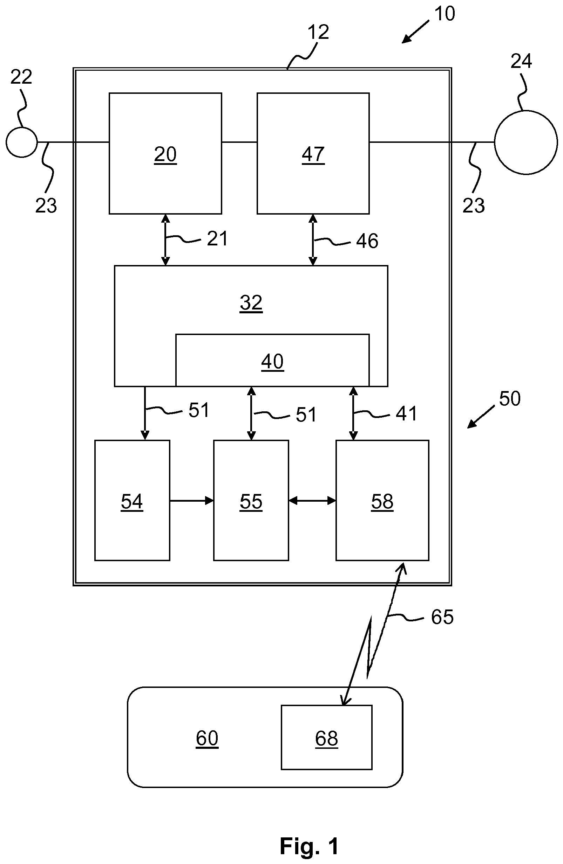

In **Fig. 1****,** schematically a first embodiment is depicted, showing a measuring and monitoring relay apparatus 10. The relay apparatus 10 controls a line 23, which connects a load 24 to a power line 22. The line 23 may be one ore more lines, the line 23 may control DC and AC power, where a broad variety of aspects may be controlled. These aspects may comprise monitoring and/or protection of overcurrent, undercurrent, and/or current windows, overvoltage, undervoltage, and/or voltage windows, phase failure monitoring and/or correction, and/or further aspects. The line 23 is controlled by a relay or contactor 20, within a housing 12. The contactor 20 may comprise, for instance, a mechanically moveable relay, a MOSFET, an IGBT, and/or other switching elements. The current and/or voltage is sensed or monitored by a sensor or monitoring means 47. The monitoring means 47 is connected via interface 46 to a controller or processor 32, which controls the contactor 20 via an interface 21. At least some of the control parameters (often the variable ones) of the relay apparatus 10 are stored in a configuration module 40. The control parameters may be transferred via interface 41, which is connected to the configuration module 40 and/or processor 32. The interface 41 is connected to an NFC transmitter/receiver 58. The NFC transmitter/receiver 58 is galvanically decoupled from an outside environment. Control parameters or configuration may come from an NFC reader 60, via NFC transmitter/receiver 68, interface 65, NFC transmitter/receiver 58, and interface 41 to configuration module 40.

Furthermore, the relay apparatus 10 comprises an audit device 50. The audit device 50 is connected to the processor 32 and/or other components of the relay apparatus 10 via an audit interface 51 (connections to the other components are not shown). The audit interface 51 is configured to transfer audit data from at least one component of the relay apparatus 10, wherein the audit data are a function of a state of the at least one component and/or of an environment of the electronic relay apparatus 10, to the audit device 50. The audit device 50 further comprises a non-volatile memory, comprising at least an error logging module 54 and a data storage module 55. The error logging module 54 contains an error log of the relay apparatus 10, i.e. logged data that inform, e.g., about audit data like supply voltage, device temperature, measured maximum and minimum values, etc. Logged data may comprise all kind of data that can be used to give a hint for a damage cause and/or root cause, particularly in cases when a damage has occurred. Further data in the error logging module 54 may, for example, comprise temperature evolution over time, possibly a strong or extreme temperature increase, an unusual voltage drop or voltage spike on the supply line, etc. The data storage module 55 contains, at least, a copy of the configuration data. The audit data from the non-volatile memory, i.e. error logging module 54 and data storage module 55, can be read - during operation and/or even after many types of damage - via the NFC transmitter/receiver or reading interface 58 over interface 65. The reading may be performed by the NFC reader 60, via NFC transmitter/receiver 68. The NFC reader 60 may use the audit data, or at least parts of them, to configure other relay apparatuses and/or for analysis.

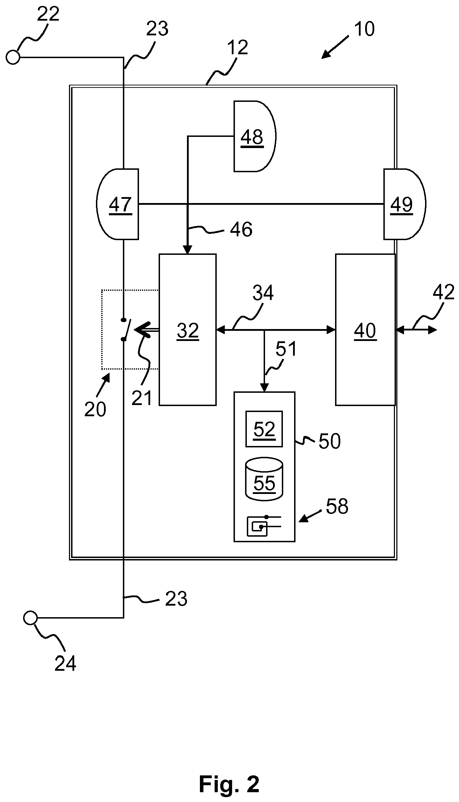

In **Fig. 2****,** a second embodiment is depicted schematically, showing a measuring and monitoring relay apparatus 10. Same elements as in **Fig. 1** have the same reference signs. The relay apparatus 10 controls a line 23, which connects a load 24 to a power line 22. The line 23 may be one ore more lines, the line 23 may control DC and AC power, where a broad variety of aspects may be controlled. The line 23 is controlled by a relay or contactor 20, within a housing 12. The current and/or voltage is sensed or monitored by a sensor or monitoring means 47. The monitoring means 47 is connected via interface 46 to a controller or processor 32, which controls the contactor 20 via an interface 21. Further sensors 48 and 49, which capture inside environment data of the relay apparatus 10 or outside environment data, respectively. The environment data may comprise, e.g., a temperature, an air pressure, a humidity or wetness, an electric field, and/or a magnetic field. At least some of the control parameters of the relay apparatus 10 are stored in a configuration module 40 and connected to the processor 32 via interface 34. The control parameters may be transferred via (optional) interface 42 and/or wirelessly via an NFC transmitter/receiver 58 and an interface 51.

The relay apparatus 10 comprises an audit device 50, which is designed as a separate subsystem. This embodiment of the audit device 50 may be physically coupled or separated from other components of the relay apparatus 10. The audit interface 51 may be coupled wirelessly or wired to the processor 32 and/or configuration module 40. Connection to the other components of the relay apparatus 10 may be provided via processor 32 and/or other lines or interfaces (connections to the other components are not shown). The audit interface 51 is configured to transfer audit data from at least one component of the relay apparatus 10, wherein the audit data are a function of a state of the at least one component and/or of an environment of the electronic relay apparatus 10, to the audit device 50. The audit device 50 further comprises a non-volatile memory 55, comprising at least an error logging module and a data storage module. The error logging module contains an error log of the relay apparatus 10. The data storage module contains, at least, a copy of the configuration data. The audit data from the non-volatile memory 55 can be read - during operation and/or even after many types of damage - via the reading interface 58, over an air interface, which may be realized by an optocoupler, NFC protocol, Bluetooth, and/or other means or protocols. In case of an NFC protocol, a NFC reader (like the one of **Fig. 1**) may be used for reading, for other protocols, respective devices may be used.

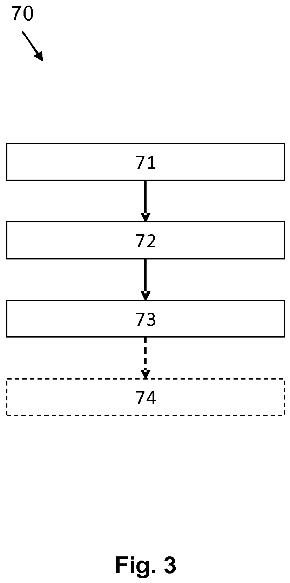

**Fig. 3** depicts schematically a flow diagram 70 of a method according to an embodiment. In a step 71, audit data are transferred from at least one component of the relay apparatus 10 (cf. **Fig. 1** or **2**) via an audit interface 51 to a non-volatile memory 54, 55. The audit data are a function of a state of the at least one component and/or of an environment of the electronic relay apparatus 10. In a step 72, the audit data are stored the in the non-volatile memory 54, 55. In a step 73, the audit data are read from the non-volatile memory 54, 55 via a reading interface 58.

In an optional step 74, at least parts of the audit data are evaluated. The evaluation may be performed in a live-analysis and/or even in a post-mortem analysis. The evaluation may comprise comparing the audit data with a functional model of at least one component of the relay apparatus 10, comparing the audit data with a history of the audit data of the relay apparatus 10, and/or comparing the audit data with a collection of a history of the audit data of other relay apparatuses 10. Additonally or alternatively, optional step 74 may comprise copying at least a subset of the first set of the audit data to an external reader 60. This may be used, e.g., for transferring the subset of the first set of the audit data from the external reader 60 to another relay apparatus 10.

### LIST OF REFERENCE SIGNS

- 10: relay apparatus
- 12: housing
- 20: contactor
- 21: interface
- 22: power line
- 23: line
- 24: load
- 32: processor
- 34: interface
- 40: configuration module
- 41: interface
- 42: interface
- 46: via interface
- 47: monitoring means
- 48, 49: sensors
- 50: audit device
- 51: audit interface
- 54: non-volatile memory, logging module
- 55: non-volatile memory, storage module
- 58: NFC transmitter/receiver, reading interface
- 60: external reader
- 65: interface
- 68: NFC transmitter/receiver
- 70: flow diagram
- 71, 72, 73, 74: steps

## Claims

1. An audit device (50) for auditing an electronic relay apparatus (10) at least partly, the audit device (50) comprising:
an audit interface (51), configured to transfer audit data from at least one component of the relay apparatus (10), wherein the audit data are a function of a state of the at least one component and/or of an environment of the electronic relay apparatus (10), to the audit device (50);
a non-volatile memory (54, 55), configured to store the audit data; and
a reading interface (58), configured to read the audit data from the non-volatile memory (54, 55).

2. The audit device (50) of claim 1,
wherein the status data of the at least one component comprise at least one of:
a status, an error log, a supply voltage, operating voltage, operating current, operating times, and/or configuration data of the at least one component of the electronic relay apparatus (10), and
wherein the environment data of the relay apparatus (10) comprise inside environment data and/or outside environment data of at least one of:
a temperature, an air pressure, a humidity or wetness, an electric field, and/or a magnetic field.

3. The audit device (50) of any one of the preceding claims,
wherein at least a first set of the audit data is overwritten, and/or
wherein a second set of the audit data, which is distinct from the first part, is protected from being overwritten, and/or
wherein a third set of the audit data, which is a subset of the second part, comprises a history of the audit data.

4. The audit device (50) of any one of the preceding claims,
wherein the reading interface (58) is galvanically decoupled from an outside environment, and/or the reading interface (58) is further configured to transfer data from outside the relay apparatus (10) to the components of the relay apparatus (10), and vice versa.

5. The audit device (50) of any one of the preceding claims,
wherein the audit interface (51) and/or the reading interface (58) is galvanically decoupled from the other components of the relay apparatus (10), and/or
wherein the power supply of the audit device (50) is provided via the audit interface (51) and/or the reading interface (58).

6. The audit device (50) of any one of the preceding claims,
wherein the audit device (50) is detachably arranged inside a housing (12) of the electronic relay apparatus (10), and/or
wherein at least parts of the audit device (50) are mechanically, thermally, chemically, electrically, and/or magnetically, protected from the other components of the relay apparatus (10).

7. A method for auditing an electronic relay apparatus (10) at least partly, the method comprising the steps of:
- transfering audit data from at least one component of the relay apparatus (10) via an audit interface (51) to a non-volatile memory (54, 55), wherein the audit data are a function of a state of the at least one component and/or of an environment of the electronic relay apparatus (10);
- storing the audit data in the non-volatile memory (54, 55); and
- reading the audit data from the non-volatile memory (54, 55) via a reading interface (58).

8. The method of claim 7, comprising the further step of:
- overwriting a first set of the audit data,
wherein a second set of the audit data, which is distinct form the first part, is protected from being overwritten.

9. The method of claim 7 or 8, comprising the further steps of:
- copying at least a subset of the first set of the audit data to an external reader (60); and
- transferring the subset of the first set of the audit data from the external reader (60) to another relay apparatus (10).

10. The method of any one of the claims 7 to 9, comprising the further step of:
- evaluating at least parts of the audit data by at least one of:
comparing the audit data with a functional model of at least one component of the relay apparatus (10);
comparing the audit data with a history of the audit data of the relay apparatus (10); and/or
comparing the audit data with a collection of a history of the audit data of other relay apparatuses (10).

11. The method of claim 10,
wherein the evaluating is performed after a damage of the relay apparatus (10).

12. Use of an audit device (50) according to any one of claims 1 to 6 for auditing an electronic relay apparatus (10) at least partly, wherein the electronic relay apparatus (10) is one of: a thermistor relay, a timer relay, a safety relay, an interface relay, an overload relay, a relay for monitoring and/or protection of DC and AC currents and/or voltages, single-phase or multi-phase, for monitoring and/or protection of overcurrent, undercurrent, and/or current windows, overvoltage, undervoltage, and/or voltage windows, phase failure monitoring and/or correction, and/or a combination of these types.

13. A computer program product comprising instructions, which, when the program is executed by a computer, cause the computer to carry out the method according to claims 7 to 11.

14. A computer-readable storage medium where a computer program according to claim 13 is stored on.

15. Electronic relay apparatus (10) comprising an audit device (50) of any one of claims 1 to 6.
